**Europäisches Patentamt**

**European Patent Office**

**Office européen des brevets**

(19)

(11) Numéro de publication : **0 383 665 B1**

(12)

# FASCICULE DE BREVET EUROPEEN

(45) Date de publication du fascicule du brevet :
**29.12.93 Bulletin 93/52**

(51) Int. Cl.$^5$ : **C04B 41/87,** C04B 41/45, C04B 41/50

(21) Numéro de dépôt : **90400375.3**

(22) Date de dépôt : **12.02.90**

(54) **Procédé de dépôt en phase vapeur à basse température d'un revêtement céramique du type nitrure ou carbonitrure métallique.**

(30) Priorité : **16.02.89 FR 8902045**

(43) Date de publication de la demande :
**22.08.90 Bulletin 90/34**

(45) Mention de la délivrance du brevet :
**29.12.93 Bulletin 93/52**

(84) Etats contractants désignés :
**AT BE CH DE DK ES FR GB GR IT LI LU NL SE**

(56) Documents cités :
EP-A- 0 095 963
US-A- 4 393 097
CHEMICAL ABSTRACTS, vol. 74, no. 16, 19 avril 1971, page 161, abrégé no. 78827x, Columbus, Ohio, US; B.G. Gribov et al.: "Metallic films obtained by the pyrolysis of pi-complexes of chromium and molybdenum in the gas phase" & Dokl. Akad. Nauk SSSR 1970, vol. 194, no. 3, pages 580-582

(73) Titulaire : **NITRUVID**
**9, Rue Jean Poulmarch Zone Industrielle Duval**
**F-95100 Argenteuil (FR)**
Titulaire : **FORTECH**
**La Défense 9 - 4, Place de la Pyramide**
**F-92800 PUTEAUX (FR)**

(72) Inventeur : **Nowak, Jean-Francois**
**33, Place Fourneyron**
**F-42000 Saint Etienne (FR)**
Inventeur : **Schuster, Frédéric**
**8, Boulevard Bonrepos**
**F-31000 Toulouse (FR)**
Inventeur : **Maury, Francis**
**13, rue Bernard Dard**
**F-31320 Labege (FR)**
Inventeur : **Morancho, Roland**
**69, rue Pierre Cazeneuve**
**F-31200 Toulouse (FR)**

(74) Mandataire : **Le Guen, Gérard et al**
**CABINET LAVOIX 2, place d'Estienne d'Orves**
**F-75441 Paris Cédex 09 (FR)**

EP 0 383 665 B1

## Description

La présente invention concerne un procédé de dépôt de revêtement de type céramique à base de nitrures ou carbonitrures de chrome ou d'autres éléments métalliques tels que Cr, V, Zr, W, Mo, Co, Mn, Ni, Hf et Ta dans lequel on dépose le revêtement de type céramique à basse température et en une seule étape.

La réalisation de revêtements de type nitrures ou carbonitrures d'éléments métalliques par la technique de dépôt chimique en phase vapeur à partir d'un cément est bien connue du brevet FR. 2 527 226.

L'obtention de la vapeur métallique est réalisée par action d'un halogènure, sur un cément pulvérulent, constitué par l'élément à déposer, par exemple du chrome ou du ferrochrome lorsqu'il s'agit d'une chromisation, à des températures relativement élevées comprises entre 900 et 1100°C selon la nature du revêtement à réaliser, en présence d'une atmosphère réductrice ou neutre et d'ammoniac.

On connait par ailleurs des procédés de dépôt de chrome réalisés à basse température. Dans la publication B.B.OWEN and R.T. WEBBER, Trans. AIME 175 (1948) 693, on a décrit un procédé de dépôt à base de chrome par voie gazeuse à partir du composé (hexacarbonyl) chrome à des températures comprises entre 250 et 650°C. Toutefois, l'adhérence de ces revêtements est aléatoire et l'analyse de leur composition révèle de fortes teneurs en oxygène provenant de la décomposition des groupements carbonyles.

La publication B.D. NASH, T.T. CAMPBELL and F.E. BLOCK US Bureau of Mines, Report Investigation 7112, Washington 1968, décrit un procédé de revêtement à base de chrome par voie gazeuse à partir d'un précurseur de métal exempt d'oxygène, le di (benzène) chrome, à des températures de 300 à 500°C. Les dépôts obtenus contiennent des quantités variables de carbone.

Le but de la présente invention est la réalisation à basse température de couches monophasées de nitrures ou carbonitrures de chrome ou d'autres éléments métalliques sur des substrats de nature diverse par la technique de dépôt chimique en phase vapeur de manière à éviter les inconvénients des traitements à haute température.

A cet effet, on a élaboré un procédé qui utilise simultanément une source organo-métallique qui permet des dépôts de carbone et de métal à basse température et une source d'azote pour obtenir des revêtements de type céramique à basse température sur des substrats de nature diverse.

La présente invention a ainsi pour objet un procédé de dépôt en une étape d'un revêtement de type céramique à base de nitrures ou carbonitrures d'au moins un élément métallique choisi parmi Cr, V, Zr, W, Mo, Co, Mn, Ni, Hf et Ta sur un substrat métallique ou céramique, massif ou obtenu à partir de fibres, par dépôt en phase vapeur, caractérisé en ce que l'on dépose sur le substrat un revêtement par voie chimique, sous une pression inférieure à 10 KPa, à une température inférieure à 600°C et en utilisant un système de précurseurs constitué simultanément :

- d'un précurseur organo-métallique dudit élément métallique choisi parmi les composés organo-métalliques de type sandwich de formule générale

$$[Ar^1 M Ar^2_n] L_x L'_y$$

dans laquelle $Ar^1$ et $Ar^2$ identiques ou différents représentent un cycle aromatique en $C_5$-$C_8$ éventuellement substitué par 1 à 6 groupes alkyle en $C_1$-$C_4$ ou un groupe phényle, n représente 0 ou 1, M représente l'élément métallique tel que défini ci-dessus L et L' représentent isolément un atome d'hydrogène ou d'halogène, un groupe CO, $CF_3$, R, RCN, $PR_3$, SR, SeR, R étant un groupe alkyle en $C_1$-$C_4$ ou phényle éventuellement substitué par 1 ou 2 groupes alkyle en $C_1$-$C_4$, pyridyne, tétrahydrofuranne, acétylacétonate, tétracyanoquinodiméthane ou L et L' représentent ensemble avec M un cycle $MS_4$ ou $MS_5$ et x + y représentent de 0 à 4.
- d'un précurseur d'azote choisi parmi l'ammoniac et l'hydrazine

Un premier groupe de composés de type sandwich utilisés, sont ceux où l'élément métallique (M) est lié au moyen de liaisons du type $\pi$ coordinées à un ou deux cycles aromatiques. Dans le cas où M est lié à deux cycles, M est situé entre les plans formés par les deux cycles.

Dans ce groupe de composés le métal est à l'état zéro valent.

Comme exemples de tels composés, on peut citer les complexes du :
- chrome : $Cr(C_5H_5)_2$, $Cr(C_6H_6)_2$,
- vanadium : $V(C_5H_5)_2$, $V(C_6H_6)_2$, $V(C_5H_5) (C_7H_7)$,
- tungstène : $W(C_6H_6)_2$,
- molybdène : $Mo(C_6H_6)_2$,
- cobalt : $Co(C_5H_5)_2$,
- manganèse : $Mn[C_5H_4(CH_3)_2]$ , $[Mn(C_5H_5)_2]_n$ (qui est un composé polymère),
- nickel : $Ni(C_5H_5)_2$, $Ni[C_8H_7(C_6H_5)]_2$, (cycle aromatique à 8 atomes de carbone substitué par un groupe phényle).

Un second groupe est constitué par les composés dans lesquels l'élément métallique (M) est lié d'une part à un cycle ou deux cycles aromatiques (Ar$^1$ et Ar$^2$) au moyen de liaisons $\pi$ coordinées, et d'autre part à des ligands L et L', au moyen de liaisons qui peuvent être covalentes ou de coordination. Le nombre de ligands L et L' est fonction de la nature du ligand et de la nature du métal.

Comme exemples de composés dans lesquels les ligands L et L' sont liés au moyen de liaisons covalentes, on trouve :

- pour le vanadium : $V(C_5H_5)_2Cl$, $V(C_5H_5)_2$ $(C_6H_5S)_2$, $V[C_5H_4(CH_3)]_2Cl_2$,
- le zirconium : $Zr(C_5H_5)_2Cl_2$, $Zr(C_8H_8)Cl_2$,
- l'hafnium : $Hf(C_5H_5)_2(CH_3)_2$,
- le tantale : $Ta(C_5H_5)_2H_3$,
- le tungstène : $W(C_5H_5)_2S_4$ (dans lequel l'élément métallique forme un cycle à 5 chaînons avec les 4 atomes de soufre),
- le molybdène : $Mo$ $(C_5H_5)Cl_2$.

Des exemples de composés dans lesquels un ou les ligands L et L' sont liés au moyen de liaisons de coordinaion sont :

- pour le vanadium : $V(C_5H_5)(CO)_4$, $V(C_6H_6)$ $(CH_3CN)_3$, $V(C_7H_7)CO$,
- le zirconium $Zr(C_5H_5)_2(CO)_2$, $Zr(C_5H_5)$ $(C_5H_7O_2)_2Cl$ ($C_5H_7O_2$ = acétylacétate), $Zr(C_8H_8)_2$ THF (THF = tétrahydrofuranne),
- l'hafnium : $Hf(C_5H_5)_2(CO)_2$,
- le tungstène : $W(C_5H_5)(C_6H_5)(CO)_3$, $W(C_7H_7)(C_6H_5Se)(CO)_2$,
- le molybdène : $Mo(C_5H_5)_2(CO)_3$,
- le colbalt : $Co[C_5(CH_3)_5](CO)_2$,
- le manganèse : $Mn(C_6H_6)(CH_3CN)_3$,
- le nickel : $Ni(C_5H_5)(CF_3)P(C_6H_5)_3$.

Toutefois le précurseur organo-métallique est choisi avantageusement parmi les composés de type sandwich dans lesquels l'élément métallique central est lié à deux cycles aromatiques identiques en $C_5$-$C_8$ éventuellement substitués par un à 6 groupes alkyle en $C_1$-$C_4$.

On effectue de préférence le dépôt à une température de 300 à 600°C.

L'invention permet en particulier de réaliser des revêtements à base de nitrures ou carbonitrures de chrome en utilisant comme précurseur le di(benzène) chrome, les bis (arène) chrome substitués par un ou plusieurs groupes alkyle ayant de 1 à 4 atomes de carbone ou le bi (cyclopentadiényl) chrome. Le précurseur organométallique préféré pour ces revêtements est le di(benzène)chrome.

Comme précurseur d'azote, on préfère l'hydrazine parce que sa stabilité thermique plus faible que celle de l'ammoniac s'accorde mieux avec les températures de décomposition de l'organo-métallique.

Dans une variante de l'invention, on introduit dans la phase gazeuse un gaz réducteur tel que l'hydrogène ou une source de carbone supplémentaire choisie parmi les hydrocarbures, de préférence le méthane ou l'éthylène. L'introduction d'une source de carbone supplémentaire permet d'enrichir en carbone les revêtements de carbonitrures.

En outre, il est possible d'obtenir des revêtements plus ou moins riche en azote, allant des carbonitrures aux nitrures en ajustant le rapport des pressions partielles en précurseur organo-métallique et en précurseur d'azote.

Le procédé de la présente invention consistant en une décomposition thermique des systèmes chimiques décrits, dans un réacteur de dépôt chimique en une seule étape dans une même installation fonctionnant en phase gazeuse à basse pression est un avantage indéniable permettant d'une part l'obtention de dépôts d'épaisseur uniforme dans des réacteurs de grande capacité et/ou sur des substrats de forme complexe et d'autre part de substantielles économies de réactifs chimiques et de fluides.

En outre, selon l'invention on peut effectuer un traitement préalable des surfaces des pièces à recouvrir, par exemple un décapage à l'aide d'un plasma, sous faible pression.

Les revêtements de nitrures ou carbonitrures métalliques sont adhérents malgré une interface nette et non diffuse. La basse température du substrat au cours du dépôt permet la conservation des propriétés mécaniques et des caractéristiques dimensionnelles de ce dernier.

Les revêtements sont obtenus sur des substrats de nature diverse : métalliques tels que les aciers, les superalliages base nickel ou cobalt, les alliages d'aluminium, les alliages de titane, les alliages de zirconium ou les céramiques telles que l'alumine ou la silice car ces alliages ne participent pas chimiquement à la réaction générant la croissance du film contrairement à la chromisation à haute température, ou les composites à matrice métallique ou céramique, les fibres de carbone, les tissus céramiques du type C-C,C-Si,SiC-SiC.

On décrira ci-après le procédé selon l'invention ainsi qu'une installation pour sa mise en oeuvre dans le cas revêtement à base de nitrures ou carbonitrures de chrome en se référant aux dessins annexés sur lesquels :

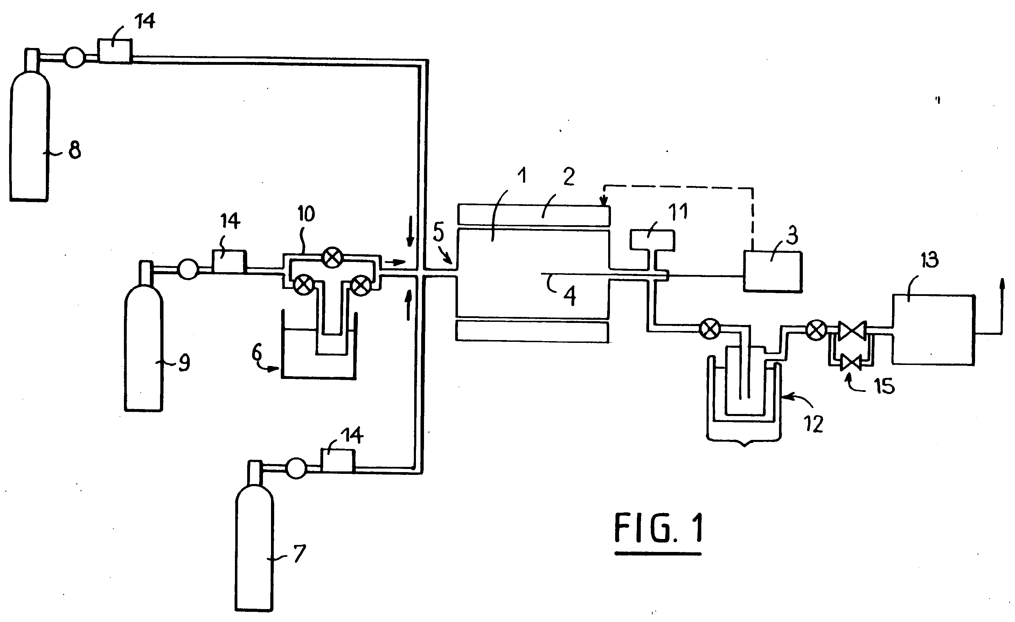

- la Fig. 1 représente un schéma d'ensemble de l'installation utilisée pour réaliser le procédé selon l'invention;
- la Fig.2 représente un diagramme des courbes intensité-potentiel en milieu $H_2SO_4$ de l'acier revêtu par un procédé selon l'invention et celle d'un acier non revêtu.

Après un nettoyage conventionnel, les substrats sont introduits dans le réacteur tubulaire horizontal de dépôt chimique en phase vapeur (C.V.D) 1. Le réacteur est associé à des résistances de chauffage 2 thermostatées, commandées par un régulateur de température 3 recevant les informations de température de la sonde 4 insérée au coeur de l'un des échantillons.

L'entrée 5 du réacteur est reliée par des conduits en acier inoxydable d'une part, soit à un saturateur en pyrex 6 contenant le précurseur organo-métallique de chrome dans le cas d'un composé solide tel que Cr $(C_6H_6)_2$, soit à un bulleur dans le cas d'un composé liquide, d'autre part à la source d'azote constituée d'une bouteille d'ammoniac 7 ou d'un bulleur thermostaté de $N_2H_4$, et enfin à une troisième ligne reliée à une bouteille de gaz 8 permettant soit une dilution par un gaz inerte pour ajuster la composition de la phase gazeuse initiale ainsi que l'hydrodynamique soit l'addition d'un gaz réducteur tel que $H_2$ ou d'une source de carbone comme $CH_4$.

Le saturateur 6 reçoit en entrée un débit de gaz inerte (He ou Ar) provenant de la bouteille 9. Des vannes permettent de balayer le substrat par le gaz inerte à l'aide de la dérivation 10 ou au contraire de faire passer le gaz inerte sur le précurseur source de chrome, le di(benzène) chrome par exemple.

Dans une phase préalable, les conduits sont purgés par des séquences alternées mise sous vide-remplissage de gaz inerte suivi par un pompage dynamique durant plusieurs heures, qui assure un vide primaire de 0,13 Pa dans le réacteur.

Le gaz inerte provenant de la bouteille 9 est ensuite délivré par la dérivation 10 afin de remplir le réacteur et les conduits à un débit correspondant au débit de consigne de l'expérience. La sortie du réacteur 1 est reliée à une jauge de pression 11 et à un piège à azote liquide 12 destiné à condenser les produits volatils issus de la pyrolyse et à protéger le système de pompage 13 utilisé pour maintenir une basse pression dans le réacteur. Le débit est fixé et régulé par le débimètre massique 14. La pression est ensuite abaissée au voisinage de la pression de travail au moyen de la vanne 15. Le réacteur est ensuite chauffé par le four à résistances électriques 2 jusqu'à la température de consigne.

Après une stabilisation de tous les paramètres durant environ 15 minutes, l'ammoniac (ou l'hydrazine) est introduit dans le réacteur suivi par les vapeurs du dérivé organo-métallique de l'élément métallique en ouvrant le saturateur 6 et en fermant la dérivation 10, et la pression dans le réacteur est ajustée à la valeur de consigne au moyen de la vanne 15.

L'expérience de dépôt commence et se déroule sans aucune intervention.

A l'issue de celle-ci, le saturateur 6 est mis hors circuit, le gaz inerte est à nouveau mis en circulation dans la dérivation 10 et l'alimentation en $NH_3$ (ou hydrazine) est coupée. Le chauffage est maintenu pendant une durée comprise entre 5 et 30 mn. La phase de refroidissement commence avec une vitesse moyenne relativement lente, comprise entre 1 et 10°C/mn. Lorsque le réacteur est à température ambiante, le substrat revêtu peut être retiré.

Des conditions opérationnelles typiques pour la mise en oeuvre du procédé sont les suivantes :
- pression totale : $10^{-2}$ à 10 kPa
- température du substrat : 300 à 600°C
- pression partielle de $NH_3$ ($pNH_3$) : 0 à 200 Pa
- pression partielle de Cr $(C_6H_6)_2$ : 0,5 à 20 Pa
- $pNH_3/pCr$ $(C_6H_6)_2$ : 0 à 100
- débit total de gaz : 0,25 à 0,50 Pa.m³s⁻¹ (diamètre de réacteur : 15 mm).

Afin de bien montrer l'objet de l'invention on va décrire ci-après deux exemples non limitatifs de réalisation de couches de $Cr_2(C,N)$ et CrN sur des substrats en acier inoxydable austénitique.

Les analyses suivantes sont effectuées sur les substrats recouverts : analyse par spectroscopie électronique pour l'analyse chimique (E.S.C.A. ) qui révèle la présence des éléments Cr, C, N avec notamment des énergies de liaison, pour le carbone et l'azote, caractéristiques des carbures et des nitrures métalliques ; analyse par microsonde électronique donnant la composition globale du dépôt, analyse par spectroscopie à décharge luminescente du profil de concentration des éléments, mesure de microdureté Vickers, mesure de comportement électrochimique par détermination des courbes intensité-potentiel du milieu $H_2SO_4$ 1M et test d'adhérence au ruban adhésif.

Le test d'adhérence consiste à rayer la couche selon un quadrillage puis à coller un morceau de ruban adhésif sur celle-ci et à arracher le ruban adhésif.

L'épaisseur du revêtement et donc la vitesse de croissance de celui-ci sont mesurées au microscope électronique à balayage, ce dernier renseigne également sur la morphologie du revêtement. Enfin, l'analyse par diffraction de rayons X montre la structure amorphe ou cristallisée du revêtement.

EXEMPLE 1 :

Un substrat plat en acier inoxydable de 1 mm d'épaisseur est préalablement poli, rincé aux ultrasons dans de l'alcool puis séché à l'air comprimé sec afin d'obtenir une surface propre et bien dégraissée. Les conditions expérimentales pour le dépôt du revêtement sont les suivantes :
- Température du substrat : 420°C
- Débit de $NH_3$ : 0,08 Pa.m³ s⁻¹
- Pression : 300 Pa
- Tension de vapeur du précurseur de Cr : 9,3 Pa
- Débit d'hélium sur précurseur : 0,25 Pa m³ s⁻¹
- Durée de dépôt : 1 h 30

Les analyses et tests ont fourni les résultats suivants : le revêtement est un carbonitrure de chrome de composition Cr $C_{0,26}$ $N_{0,36}$ que l'on peut écrire $Cr_2$ (C,N), de structure amorphe, d'aspect lisse et métallique. Le test au ruban adhésif ne fait apparaître aucun décollement de matière, ce qui démontre une bonne adhérence. Le profil de concentration par spectroscopie à décharge luminescente montre une répartition homogène en profondeur des éléments Cr, C, N dans le revêtement. La microdureté superficielle du substrat de 2450 N/mm² devient après dépôt égale à 24500 N/mm² sous une charge de 50 grammes.

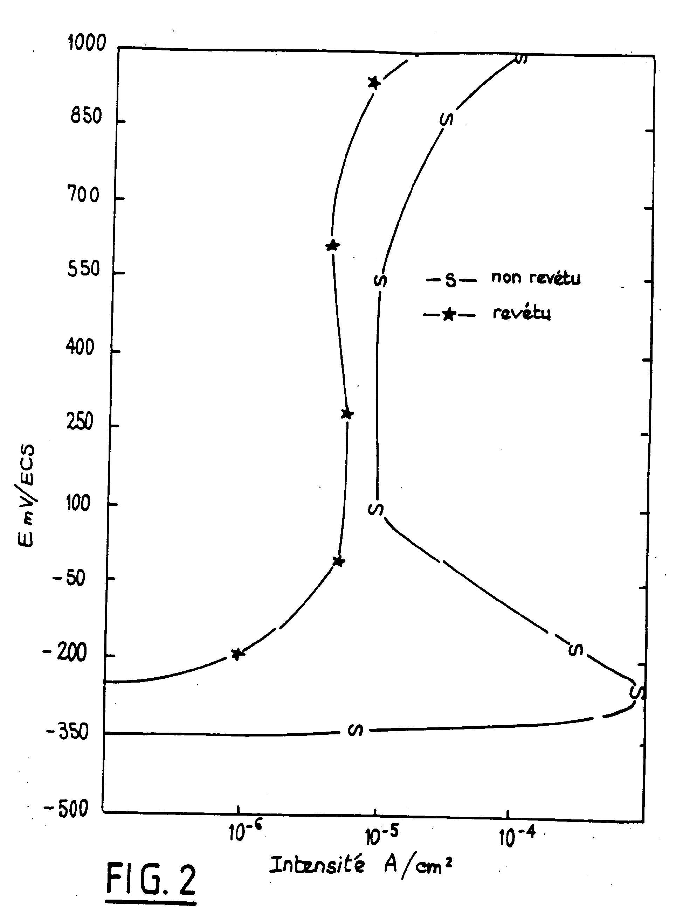

La figure 2 fournit la courbe intensité-potentiel en milieu $H_2SO_4$ 1M de l'acier non revêtu et celle de l'acier revêtu. En abscisse sont portées les densités de courant en A/cm2 et en ordonnée les potentiels en millivolts par rapport à l'électrode au calomel saturé. On constate que le revêtement conduit à un anoblissement du potentiel de corrosion, avec apparition d'un palier de passivité. D'autre part, il n'y a plus de pic d'activité comme sur l'acier non revêtu. Des expérimentations répétées démontrent la parfaite reproductibilité de ces résultats.

La vitesse de croissance du film est de 10 µm/h, l'épaisseur du revêtement est de 15 µm en 1h30 d'expérience de dépôt.

EXEMPLE 2

Un substrat plat en acier inoxydable austénitique de 1 mm est préparé dans les mêmes conditions que dans l'exemple 1. Les conditions expérimentales pour le dépôt du revêtement sont les suivantes :
- Température du substrat : 530°C
- Débit de $NH_3$ : 0,085 Pa.m³ s⁻¹
- Pression : 300 Pa
- Tension de vapeur du précurseur de Cr : 9,3 Pa
- Débit d'hélium sur précurseur de Cr = 0,25 Pa.m³ s⁻¹
- Durée de dépôt : 1h30

L'analyse par diffraction de rayons X révèle nettement la phase cristallisée CrN. Le dosage par microsonde donne la composition chimique globale Cr $N_{1,1}$, $C_{0,05}$ et l'E.S.C.A. montre la présence de carbone libre. Il s'agit donc d'un revêtement type CrN + C libre. Le test d'adhérence au ruban adhésif est satisfaisant et la microdureté est de 19600 N/mm2 sous une charge appliquée de 100 grammes. L'épaisseur est de 38 µm, soit une vitesse de croissance de 25 µm/h.

Les exemples 1 et 2 sont reportés sur le tableau 1 ci-dessous ainsi que d'autres exemples réalisés grâce au procédé de l'invention.

TABLEAU I

| Ex. | T° | Pres. (Pa) | $PNH_3/PCr$ $(C_6H_6)_2$ | CrNxCy | type | structure |
|---|---|---|---|---|---|---|
| 1 | 420 | 300 | 10 | $CrN_{0,36}C_{0,26}$ | $Cr_2(C,N)$ | amorphe |
| 2 | 530 | 300 | 40 | $CrN_{1,1}C_{0,05}$ | CrN-Clibre | cristalline |
| 3 | 400 | 300 | 10 | $CrN_{0,13}C_{0,30}$ | $Cr_2(C,N)$ | amorphe |
| 4 | 450 | 300 | 10 | $CrN_{0,5}C_{0,17}$ | $Cr_2(C,N)$ | amorphe |
| 5 | 510 | 300 | 10 | $CrN_{0,97}C_{0,14}$ | $Cr(C,N)$ | cristalline |
| 6 | 560 | 300 | 10 | $CrN_{1,2}C_{0,07}$ | CrN-Clibre | cristalline |
| 7 | 510 | 300 | 0 | $CrN_0C_{0,39}$ | $Cr_7C_3$ | cristalline |
| 8 | 510 | 300 | 60 | $CrN_{1,03}C_{0,08}$ | CrN-Clibre | cristalline |

La forte teneur en chrome (entre 75 et 90% en poids), le niveau élevé de dureté ( entre 18000 et 30000 unités sous une charge de 50g) et la structure hexagonale avec plan de densité maximale orienté parallèlement à la surface du substrat pour Cr2N et Cr2(C,N) cristallisé autorisent une bonne résistance à la corrosion, au frottement et à l'usure.

**Revendications**

1. Procédé de dépôt en une étape d'un revêtement de type céramique à base de nitrures ou carbonitrures d'au moins un élément métallique choisi parmi Cr, V, Zr, W, Mo, Co, Mn, Ni, Hf et Ta, sur un substrat métallique ou céramique, massif ou obtenu à partir de fibres, par dépôt en phase vapeur, caractérisé en ce que l'on dépose sur le substrat un revêtement par voie chimique sous une pression inférieure à 10 KPa, à une température inférieure à 600°C et en utilisant un système de précurseurs constitué :
   - d'un précurseur organo-métallique dudit élément métallique choisi parmi les composés organo-métalliques de type sandwich de formule générale
$$[Ar^1 M Ar^2_n] L_x L'_y$$
dans laquelle $Ar^1$ et $Ar^2$ identiques ou différents représentent un cycle aromatique en $C_5$-$C_8$ éventuellement substitué par 1 à 6 groupes alkyle en $C_1$-$C_4$ ou un groupe phényle, n représente 0 ou 1, M représente l'élément métallique tel que défini ci-dessus, L et L' représentent isolément un atome d'hydrogène ou d'halogène, un groupe CO, $CF_3$, R, RCN, $PR_3$, SR, SeR, R étant un groupe alkyle en $C_1$-$C_4$ ou phényle éventuellement substitué par 1 ou 2 groupes alkyles en $C_1$-$C_4$, pyridyne, tétra-

hydrofuranne, acétylacétonate, tétracyanoquinodiméthane ou L et L' représentent ensemble avec M un cycle $MS_4$ ou $MS_5$ et x + y représentent de 0 à 4, et
- d'un précurseur d'azote choisi parmi l'ammoniac et l'hydrazine.

2. Procédé selon la revendication 1, caractérisé en ce que le précurseur organo-métallique est choisi parmi les composés de type sandwich dans lesquels l'élément métallique central est lié à deux cycles aromatiques identiques en $C_5$-$C_8$, éventuellement substitués par un à six groupes alkyle en $C_1$-$C_4$.

3. Procédé selon la revendication 1, caractérisé en ce que la température du substrat lors du dépôt est comprise entre 300 et 600°C.

4. Procédé selon la revendication 2, caractérisé en ce que l'élément métallique est le chrome et le précurseur organo-métallique est choisi parmi le di (benzène) chrome, les bis (arène) chrome substitués par un à six groupes alkyle en $C_1$-$C_4$ et le bis (cyclopentadiényl) chrome.

5. Procédé selon la revendication 4, caractérisé en ce que le précurseur d'azote est l'hydrazine et le précurseur organo-métallique est le di(benzène) chrome.

6. Procédé selon l'une quelconque des revendications précédentes, caractérisé en ce qu'on introduit dans la phase vapeur un gaz réducteur ou une source de carbone choisie parmi les hydrocarbures.


## Patentansprüche

1. Verfahren zum einstufigen Abscheiden eines keramischen Überzugs auf der Basis von Nitriden oder Carbonitriden von wenigstens einem metallischen Element aus Cr, V, Zr, W, Mo, Co, Mn, Ni, Hf und Ta auf einem metallischen oder keramischen Substrat, das massiv ist oder aus Fasern erhalten wird, durch Abscheiden aus der Dampfphase, dadurch gekennzeichnet, daß man auf dem Substrat einen Überzug auf chemischem Wege abscheidet, unter einem Druck, der kleiner ist als 10 KPa, bei einer niedrigeren Temperatur als 600°C und unter Benutzung eines Zwischenstoffsystems, das aus folgendem besteht:
- einem organometallischen Zwischenstoff des metallischen Elementes, der gewählt wird unter den organometallischen Komponenten der Art Sandwich mit der allgemeinen Formel
$$[ Ar^1 M Ar^2_n ] L_x L'_y$$
bei der $Ar^1$ und $Ar^2$ , die identisch oder verschieden sind. cincn Aromatenring aus $C_5$-$C_8$ darstellen, der eventuell durch 1 oder 6 Alkylgruppen aus $C_1$-$C_1$ oder einer Phenylgruppe ersetzt ist, n 0 oder 1 darstellt, M ein metallisches Element so wie oben definiert darstellt, L und L' isoliert ein Hydrogen- oder Halogenatom darstellen, und zwar eine Gruppe CO, $CF_3$, R, RCN, $PR_3$, SR, SeR, wobei R eine Alkylgruppe aus $C_1$-$C_1$ oder Phenylgruppe ist, die eventuell durch 1 oder 2 Alkylgruppen aus $C_1$-$C_4$, Pyridin, Tetrahydrofuran, Acetylacetonat, Tetracyanoquinodimethan ersetzt ist, oder L und L' stellen zusammen mit M einen Ring $MS_4$ oder $MS_5$ dar und x + y stellen von 0 bis 4 dar, und
- einem Stickstoff-Zwischenstoff, der aus Ammoniak und Hydrazin gewählt ist.

2. Verfahren gemäß Anspruch 1, dadurch gekennzeichnet, daß der organometallische Zwischenstoff unter den Komponenten der Art Sandwich gewählt wird, bei denen das zentrale metallische Element mit zwei identischen Aromatenringen aus $C_5$-$C_8$ verbunden ist, die eventuell durch eine bis sechse Alkylgruppen aus $C_1$-$C_4$ ersetzt sind.

3. Verfahren gemäß Anspruch 1, dadurch gekennzeichnet, daß die Temperatur des Substrats während des Abscheidens zwischen 300 und 600°C liegt.

4. Verfahren gemäß Anspruch 2, dadurch gekennzeichnet, daß das metallische Element Chrom ist und der organometallische Zwischenstoff unter Di(Benzen)-Chrom, den Bis(Aren)-Chrom gewählt wird, die von einer bis sechs Alkylgruppen aus $C_1$-$C_4$ und dem Bis(Cyclopentadienyl)Chrom ersetzt sind.

5. Verfahren gemäß Anspruch 4, dadurch gekennzeichnet, daß der Stickstoff-Zwischenstoff Hydrazin und der organometallische Zwischenstoff Di(Benzen)Chrom ist.

6. Verfahren gemäß irgendeinem der vorherigen Ansprüche, dadurch gekennzeichnet, daß man in die Dampfphase ein Reduziergas oder eine Kohlenstoffquelle einführt, die aus den Kohlenwasserstoffen gewählt ist.

## Claims

1. A process for single-stage deposition of a ceramic-type coating with a base of nitrides or carbonitrides of at least one metallic element selected from Cr, V, Zr, W, Mo, Co, Mn, Ni, Hf and Ta, on a metal or ceramic substrate which is solid or formed from fibres, by vapour-phase deposition, **characterised in that** a coating is deposited on the substrate by chemical means at a pressure lower than 10 KPa, at a temperature less than 600°C and using a precursor system comprising:
   - an organometallic precursor of the said metallic element selected from amongst the sandwich-type organometallic compounds of the general formula
   $$[ Ar^1 M Ar^2{}_n]L_x L'_y$$
   wherein $Ar^1$ and and $Ar^2$ are identical or different and represent an aromatic ring of $C_5$ - $C_8$, optionally substituted by 1 to 6 alkyl groups of $C_1$ - $C_4$, or a phenyl group;
   n represents 0 or 1;
   M represents the metallic elcment as defined above; and
   L and L' individually represent a hydrogen or halogen atom;
   a CO, $CF_3$, R, RCN, $PR_3$, SR, SeR group, R being an alkyl group of $C_1$ - $C_4$, or phenyl, optionally substituted by 1 or 2 alkyl groups of $C_1$ - $C_4$;
   pyridine, tetrahydrofurane, acetylacetonate, tetracyanoquinodimethane;
   or L and L' represent, together with M, an $MS_4$ or $MS_5$ ring; and x + y represent from 0 to 4, and
   - a nitrogen prccursor selected from ammonia and hydrazine.

2. A process in accordance with claim 1, **characterised in that** the organometallic precursor is selected from amongst the sandwich-type compounds in which the central metallic element is bonded to two identical aromatic rings of $C_5$- $C_8$, optionally substituted by one to six alkyl groups of $C_1$ - $C_4$.

3. A process in accordance with claim 1, **characterised in that** during deposition the temperature of the substrate is between 300 and 600°C.

4. A process in accordance with claim 2, **characterised in that** the metallic element is chromium and the organometallic precursor is selected from di(benzene)chromium, bis(arene)chromium substituted by one to six alkyl groups of C1 - C4, and bis(cyclopentadienyl)chromium.

5. A process in accordance with claim 4, **characterised in that** the nitrogen precursor is hydrazine and the organomctallic presursor is di(benzene)chromium.

6. A process in accordance with any one of the preceding claims, **characterised in that** during the vapour phase there is introduced a reducing gas, or a source of carbon selected from amongst the hydrocarbons.

FIG. 1

EP 0 383 665 B1

**FIG. 2**